Europäisches Patentamt

European Patent Office    (11) Publication number: **0 225 985**

Office européen des brevets    **A1**

(12) **EUROPEAN PATENT APPLICATION**

(21) Application number: 86114204.0

(22) Date of filing: 14.10.86

(51) Int. Cl.⁴: **H05K 3/38** , H05K 3/02 , B32B 31/12

(30) Priority: 21.10.85 US 789628

(43) Date of publication of application: 24.06.87 Bulletin 87/26

(84) Designated Contracting States: DE FR GB IT

(71) Applicant: International Business Machines Corporation
Old Orchard Road
Armonk, N.Y. 10504(US)

(72) Inventor: Babu, Suryadevara Vijayakumar
1 Carol Court
Potsdam New York 13676(US)
Inventor: Hoffarth, Joseph Gerard
Rd. No.3 Poplar Hill Road
Binghamton New York 13901(US)

(74) Representative: Neuland, Johannes, Dipl.-Ing.
Schönaicher Strasse 220
D-7030 Böblingen(DE)

(54) **Method of making a printed circuit board.**

(57) A method of making a printed circuit board is disclosed where the substrate (28) is subjected to a corona discharge prior to laminating the conductor forming metallic sheet (24,26) to the substrate (28). The corona discharge promotes good adhesion between the metallic sheet (24,26) and the substrate - (28). In the preferred embodiment, the corona discharge is carried out as one step in a continuous on-line fabrication process.

EP 0 225 985 A1

## Method of Making a printed Circuit Board

This invention relates to a method of making printed circuit boards wherein a metallic sheet is laminated to a substrate as part of the fabrication process.

Printed circuit boards are commonly used in a wide variety of electronic equipment. In general, printed circuit boards include a plurality of electrical conductors formed on a surface of an insulative substrate. Typically, the substrate is constructed of resin impregnated glass fiber cloth which has been cured into a rigid state and the conductors are formed from a sheet of copper which has been laminated onto one or more of the surfaces of the substrate. This particular combination of substrate and conductor material has proven to be highly advantageous from a cost and performance standpoint. Unfortunately, however, some problems have been experienced in obtaining good adhesion between the copper sheet and the substrate. Surface treatment with wet chemicals and/or adhesion promoting additives are widely used in an attempt to counteract this problem. However, such treatments are subject to many inherent disadvantages. These include nonuniformity of the surface modification, overstaining, and undercutting of the signal lines. Waste disposal, solvent and chemical recovery and a large number of process steps requiring a large floor space are some of the other disadvantages. Consequently, it would be immensely beneficial to replace conventional wet treatments with a dry process that does not suffer from these disadvantages.

The invention as claimed provides such a dry process. The advantages offered by the invention are that the disclosed corona discharge ca be carried out quickly and conveniently. It provides uniformity of the surface treatment and a minimum of required process steps. More importantly, it can be readily included as part of an on-line process to which all automation and process control capabilities can be applied. The surface modification is also limited to a very thin region that will act an an interface.

Below the invention is described in detail by reference to the drawings in which:

FIGURE 1 is a perspective view illustrating a continuous process for fabricating printed circuit boards in accordance with the teachings of the present invention;

FIGURE 2 is a flow chart illustrating the sequence of processing steps carried out in the preferred embodiment; and

FIGURE 3 is a partial side view - schematically illustrating apparatus for laminating sheets to a substrate.

Referring now to the drawings, reference numeral 10 generally designates a processing stage for subjecting a substrate to a corona discharge. As will be discussed later herein, the substrate may be conveyed through the processing stage 10 as part of a continuous on-line fabrication process. However, this is not critical to the broad aspects of the present invention. Stage 10 includes a high frequency power generator 12, a high voltage step-up and matching transformer 14 and a treater station assembly including one or more electrodes 16 and a dielectric covered grounded roller 18. Provision can be made, if desired, to enclose the treatment area and control the atmosphere in which the corona discharge takes place. In the drawings, this is represented schematically by hood 20, gas source 22 and valve 23. It is expected that suitable results can be obtained using oxygen, nitrogen, argon and ammonia gas in the treatment stage 10 at atmospheric or subatmospheric pressures.

The purpose of the high frequency generator 12 is to convert the normally available 60 hz electrical energy to a higher frequency more suitable for corona treatment. Preferably, generator 12 provides an output frequency in the range of 8,000-32,000 Hz. Preferably, the generator 12 is adjustable thereby providing quieter discharge, more uniform treatment, lower power requirements and the ability to match the impedance of the treater assembly. Higher frequencies lower the voltamperes required to maintain a given treatment level. The generator 12 is also used to control the amount of power to the corona discharge to the substrate. The corona discharge treatment level is expressed as watts/(930cm²/min) and is determined by the width of the substrate, the speed ( cm/min) through which the substrate is conveyed underneath the electrode 16 and the power at the corona (watts).

The transformer 14 increases the available voltage to the level needed to generate a corona between electrode 16 and roller 18 through which the substrate passes. The impedance matching function of transformer 14 serves to prolong the life of the electronic components and makes the most efficient use of generator power. If the impedances are not matched, much of the generated power can be reflected back to the generator and released as heat. Matching, or tuning, can be accomplished by changing the generated frequency or by changing taps on the transformer coil.

By way of a non-limiting example, it is expected that satisfactory results can be obtained where the corona power is about 0.2 to 1 watt/(930cm²/min). The width of the substrate can be up to 1,5 m, whereas the substrate can be conveyed underneath electrode 16 at a speed of about 4 to 14 m. per minute. However, these are just practical limits based upon the limitations of currently available equipment. Corona discharge treatment levels below 0.2/watt/(930cm²/min) are not expected to provide good results because of insufficient ion bombardment energy while levels above 1 watt/(930cm²/min) are disadvantageous because of excessive sparking and arcing.

After corona treatment, the substrate is ready to be laminated. The lamination process is shown schematically in FIGURE 3 where copper sheets 24 and 26 are laminated to opposite surfaces of substrate 28. The lamination process is well known in the art and the thus need not be described in detail. Suffice it to say that conventional heated dies 30 and 32 are used to press the subassembly together under heat and pressure for a sufficient period of time to cause the sheets to adhere to the substrate.

It is believed that the corona discharge enhances the adhesion of the metallic sheets to the substrate because of the chemical and physical process caused on the substrate surface by the energetic particles in the corona discharge. These processes include surface oxidation, free radical formation and surface activation for forming strong chemical bonds. There will also be changes in surface morphology and surface chemical composition due to localized melting and recrystallization which will promote adhesion with the metallic sheet.

The laminated board is then ready for formation of the individual electrical conductors from the metallic sheets 24 and 26. This can be accomplished in a wide variety of manners including the use of standard photolithographic techniques. The present invention has applicability to a wide variety of printed circuit board structures such as those known in the art as signal core, power core, and any other structures where lamination of metallic sheets onto the board substrate material is used.

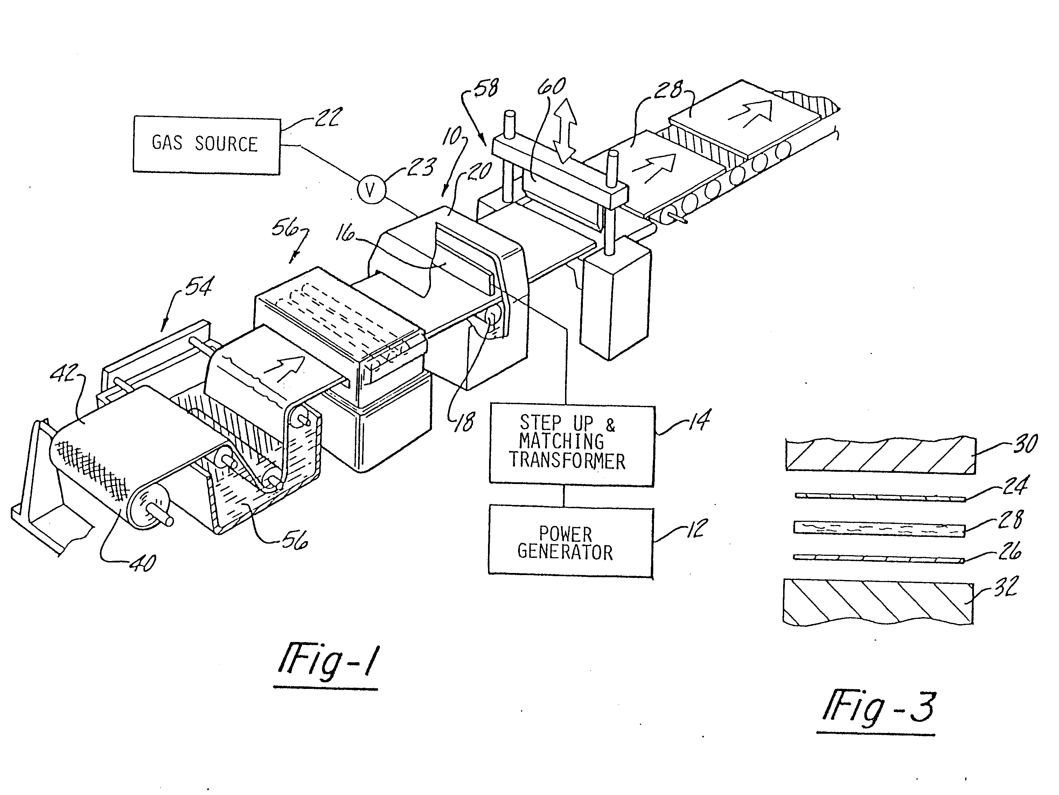

Another feature of the present invention is the incorporation of the corona discharge step into an on-line or continuous manufacturing process for mass producing the boards. One such continuous manufacturing line is shown schematically in FIGURE 1. It should be understood, however, at the outset, that FIGURE 1 only schematically illustrates the major components in the various stages of the process and that those skilled in the art will realize that other modifications can be made.

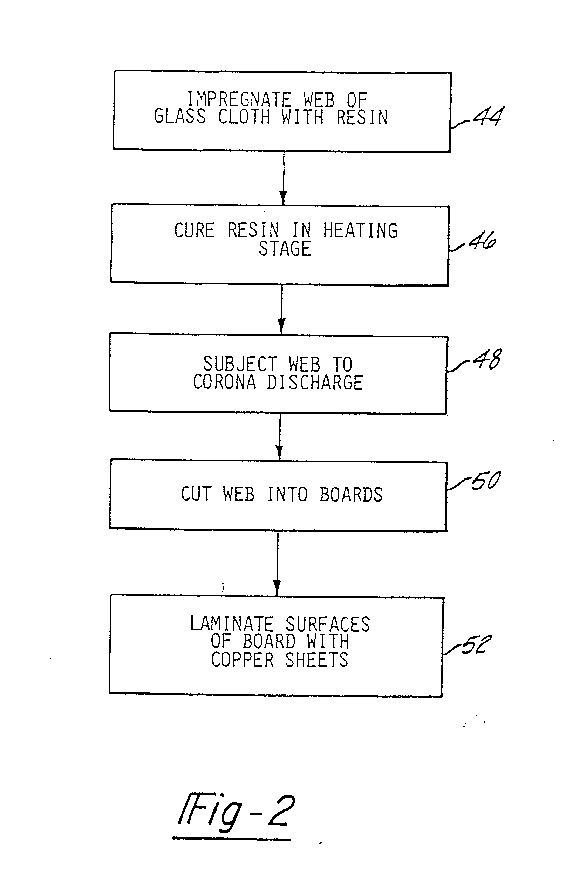

The starting material for the boards is preferably a roll 40 of glass fiber cloth which is unrolled in the form of a web 42 and pulled by suitable means, such as rollers or the like, through various processing stages. As represented by box 44 in FIGURE 2 and illustrated in FIGURE 1, the web 42 is pulled through a bath 54 of resin 56 to impregnate the fibers of the glass cloth with the resin. Suitable resins include for example phenolic, epoxy, polyester and polyamide resins.

The resin impregnated web is then passed through a second processing stage generally designated by the numeral 56 where the resin is cured by heating. Various heating methods can be used including heating by convection, or microwaves, with heating by infrared energy being the most preferred.

When the web exits the heating stage 56, it is somewhat rigid and thus is capable of being cut into individual boards at this time. Conversely, the cutting step can be carried out after the web is subjected to the corona discharge treatment in stage 10 as illustrated in FIGURE 1. The corona discharge treatment has been previously discussed herein. As shown in the drawings, the web is then cut by suitable means such as a guillotine blade 60 in cutting stage 58. The individual boards 28 are then ready for lamination as discussed above in connection with FIGURE 3.

Those skilled in the art can appreciate that the present invention provides significant advantages over conventional circuit board processing techniques. It should be understood, however, that while this invention has been described in connection with a particular example thereof, that other modifications will become apparent to a person skilled in the art after a study of the drawings, specification and following claims.

## Claims

1. A method of making a printed circuit board, characterized by
subjecting an insulative substrate to a corona discharge to promote adhesion of at least one metallic sheet to be laminated onto a surface of the substrate
laminating at least one metallic sheet onto a surface of the substrate and
forming individual conductors in the sheet.

2. The method of claim 1, characterized in that the substrate is resin impregnated glass fiber cloth.

3. The method of claim 1, characterized in that the sheet is copper.

4. The method of claim 1, characterized in that the substrate is subjected to a corona discharge treatment level of about 0.2 to 1 watt/(930cm²/min).

4. A continuous method of making a printed circuit board characterized by:
pulling a web of glass fiber cloth from a roll thereof through a bath of resin in a first treatment stage;
heating the resin impregnated web in a second treatment stage;

subjecting the web to a corona discharge treatment level of 0.2 to 1 watt/(930cm²/min) by passing the web through a third treatment stage;

cutting the web into boards at a fourth treatment stage;

laminating a copper sheet to at least one surface of the board under heat and pressure; and

forming individual electrical conductors in the copper sheet.

6. The method of claim 5, characterized in that the corona discharge is carried out in a controlled atmosphere.

7. The method of claim 5, characterized in that the third treatment stage includes an enclosure filled with a gas selected from the group of oxygen, nitrogen, argon and ammonia.

8. The method of claim 5, characterized in that the second treatment stage is adapted to subject the web to infrared energy to thereby heat the resin until it cures.

9. The method of claim 5, characterized in that the resin is selected from the group of polyesters, polyimides, phenolic and epoxy resins.

10. The method of claim 5, characterized in that the web is conveyed through the treatment stages at about 4 to 14 m per minute.

GAS SOURCE 22

STEP UP & MATCHING TRANSFORMER 14

POWER GENERATOR 12

Fig-1

Fig-3

IMPREGNATE WEB OF
GLASS CLOTH WITH RESIN — 44

CURE RESIN IN HEATING
STAGE — 46

SUBJECT WEB TO
CORONA DISCHARGE — 48

CUT WEB INTO BOARDS — 50

LAMINATE SURFACES
OF BOARD WITH
COPPER SHEETS — 52

*Fig-2*

## DOCUMENTS CONSIDERED TO BE RELEVANT

| Category | Citation of document with indication. where appropriate, of relevant passages | Relevant to claim | CLASSIFICATION OF THE APPLICATION (Int. Cl.4) |
|---|---|---|---|
| X | GB-A-2 040 101 (TOKYO SHIBAURA DENKI) * Abstract; page 2, lines 25-30; page 2, line 110 - page 3, line 57; figures 1-3 * | 1-3,5, 8,9 | H 05 K 3/38 H 05 K 3/02 B 32 B 31/12 |
| X | US-A-4 029 876 (T. BEATTY et al.) * Column 2, line 41 - column 4, line 6 * | 1-4,8, 9 | |
| A | US-A-3 661 735 (A. DRELICH) * Column 2, line 6 - column 5, line 50; figures 1-3 * | 1,5-9 | |
| A | PATENTS ABSTRACTS OF JAPAN, vol. 8, no. 118 (C-226)[1555], 31st May 1984; & JP-A-59 32 977 (SANKIYOU DENGIYOU K.K.) 22-02-1984 * Abstract * | 1 | **TECHNICAL FIELDS SEARCHED (Int. Cl.4)** H 05 K C 23 C |
| A | FR-A-2 381 081 (EBAUCHES SA) * Claims * | 1 | |

-----

The present search report has been drawn up for all claims

| Place of search | Date of completion of the search | Examiner |
|---|---|---|
| THE HAGUE | 05-03-1987 | GALLO G.G. |